**Europäisches Patentamt**

**European Patent Office**

**Office européen des brevets**

(19)

(11) Veröffentlichungsnummer: **0 095 707**
A1

# (12) EUROPÄISCHE PATENTANMELDUNG

(21) Anmeldenummer: 83105131.3

(22) Anmeldetag: 24.05.83

(51) Int. Cl.³: **C 30 B 13/00,** C 01 B 33/02,
C 30 B 29/06, C 30 B 11/00

(30) Priorität: 28.05.82 DE 3220285

(43) Veröffentlichungstag der Anmeldung: 07.12.83
Patentblatt 83/49

(84) Benannte Vertragsstaaten: DE FR IT

(71) Anmelder: SIEMENS AKTIENGESELLSCHAFT, Berlin
und München Wittelsbacherplatz 2,
D-8000 München 2 (DE)

(72) Erfinder: Mühlbauer, Alfred, Prof.-Dr.-Ing.,
Westerfeldweg 38, D-3002 Wedemark 2 (DE)

(54) Verfahren zum Herstellen polykristalliner, für nachfolgendes Zonenschmelzen geeigneter Siliciumstäbe.

(57) Zur Verbesserung des Wirkungsgrades von in der Solartechnik einsetzbaren Siliciums wird billiges im Lichtbogenverfahren gewonnenes Silicium, bevor es einem Zonenziehprozeß unterzogen wird, in Stabform gegossen, wobei die Siliciumschmelze (4) in ein horizontal angeordnetes Boot (1) gefüllt und danach mittels eines durch hierfür vorgesehene Zusatzheizer (2, 3) erzeugten, über die Bootlänge nahezu konstanten vom Bootboden zur freien Oberfläche der Schmelze verlaufenden Temperaturgradienten gesteuert zum Erstarren gebracht wird.

EP 0 095 707 A1

SIEMENS AKTIENGESELLSCHAFT
Berlin und München

Unser Zeichen
VPA

0095707

82 P 8014 E

Verfahren zum Herstellen polykristalliner, für nachfolgendes Zonenschmelzen geeigneter Siliciumstäbe

Zur großtechnischen Umwandlung von Sonnenenergie in
elektrische Energie werden bevorzugt Solarzellen aus
kristallinem Silicium eingesetzt. Dabei ist es wünschenswert, reines aber kostengünstiges Silicium einzusetzen,
aus dem sich Solarzellen mit einem hohen Wirkungsgrad
von beispielsweise mehr als 10 % herstellen lassen.

Zur Herstellung von Solarzellen mit hohem Wirkungsgrad
wird heute allgemein hochreines Silicium als Grundmaterial verwendet, das durch thermische Zersetzung von
mit Wasserstoff verdünntem, gasförmigen, hochreinen
Siliciumverbindungen wie Silicochloroform oder Siliciumtetrachlorid und Abscheidung auf widerstandsbeheizten
Siliciumdünnstäben bei einer Temperatur von ca. $1100^{o}$C
gewonnen wird. Die auf diese Weise hergestellten
Siliciumpolystäbe werden durch anschließenden Kristallziehprozeß, z. B. durch tiegelfreies Zonenschmelzen,
nachgereinigt, in einen Einkristall übergeführt, in
Scheiben zersägt, und zu Solarzellen weiterverarbeitet.
Dieses Verfahren ist technisch relativ aufwendig und
daher für großtechnische Siliciumherstellung zu teuer.

Silicium für technische Anwendungen mit einem zwar
wesentlich niedrigeren Reinheitsgrad von beispielsweise
98,5 % wird heute großtechnisch durch Reduktion von
Quarz mit Kohlenstoff im Lichtbogenofen hergestellt.
Dieser Prozeß arbeitet zwar wirtschaftlich, er ist

Bar 1 Gae / 12.05.1982

0095707

jedoch nur dann zur Herstellung von Solarsilicium geeignet, wenn es gelingt, den bisher erzielten Reinheitsgrad entscheidend zu erhöhen.

Zu diesem Zweck wurde in der deutschen Patentanmeldung P 32 10 141.4 (VPA 82 P 1201 DE) bereits vorgeschlagen, das nach dem Lichtbogenverfahren gewonnene Silicium in Stabform überzuführen und durch anschließendes, tiegelfreies Zonenschmelzen von den störenden Verunreinigungen zu befreien.

Die Praxis hat aber gezeigt, daß es nicht so ohne weiteres möglich ist, gegossenes Silicium durch Zonenschmelzen preiswert zu reinigen. Entweder wird im Gegensatz zum durch thermische Zersetzung gewonnenes Silicium dieses mit vielen Rissen, Lunkern, Bläschen, Einschlüssen und sonstigen Kristallstörungen erhalten oder der Zonenschmelzprozeß muß sehr oft, manchmal mehr als 6 bis 7 mal, wiederholt werden, um ein einigermaßen brauchbares Silicium zu erhalten.

Die Erfindung geht nun von der Erkenntnis aus, daß die technische Qualtität des zonenbezogenen Solarsiliciums wesentlich verbessert werden kann, wenn das dem Zonenschmelzprozeß zu unterwerfende Silicium bereits höhere Kristallqualität besitzt. Bei qualitativ höherwertigem Silicium gelingt es sogar mit wenigen Zonenzügen versetzungsfreies einkristallines Silicium zu gewinnen, das selbst für manche anspruchsvolleren Halbleiterbauelemente geeignet ist. Die Erfindung sieht daher vor, beim Herstellen polykristalliner, für nachfolgendes Zonenschmelzen geeignete Siliciumstäbe durch Gießen flüssigen Siliciums in formgebende Behältnisse mit anschließendem Erstarrenlassen den zonenzuschmelzenden Siliciumstab bereits beim Gießen eine so hohe Kristallqualität zu verleihen, daß an die Kristallperfektionierung
beim teueren Zonenschmelzen keine zu hohen Anforderungen
mehr gestellt werden müssen.

Gemäß vorliegender Erfindung geschieht dies dadurch, daß
die Siliciumschmelze in ein horizontal angeordnetes
Boot gefüllt und danach mittels eines durch hierfür
vorgesehene Zusatzheizer erzeugten, über die Bootlänge
nahezu konstanten, vom Bootboden zur freien Oberfläche
der Schmelze verlaufenden Temperaturgradienten gesteuert zum Erstarren gebracht wird, wobei der Temperaturgradient für die programmierte Abkühlung vom Bootsboden
zur freien Oberfläche hin durch zwei längs des Bootes
verlaufende Heizvorrichtungen erzeugt wird. Die Erstarrungsgeschwindigkeit kann damit auf 1 bis 5 mm pro
Minute eingestellt werden. Der stärkeren Abkühlung der
Bootsenden kann dadurch wirksam begegnet werden, daß die
Bootsenden stärker beheizt, also ein zusätzlicher in
Längsrichtung des Bootes von den Bootenden zur Mitte hin
verlaufender Temperaturgradient während des Erstarrens
aufrechterhalten wird.

Der Gießvorgang selbst kann entweder im Vakuum oder im
Schutzgas, z. B. Argon, bei reduziertem Druck durchgeführt werden. Bei Verwendung von Argon hat sich ein
Partialdruck von 10 Torr als besonders günstig erwiesen.

Das gemäß der Erfindung vorgesehene gerichtete Erstarren
der Siliciumschmelze bringt den großen Vorteil mit sich,
Siliciumbarren mit hoher Reinheit zu erhalten. Es werden
nämlich beim Erstarren der Schmelze ähnlich wie beim
Zonenschmelzen die Verunreinigung mit der vom Bootsboden zur freien Oberfläche hin wandernden Flüssig-Fest-
Phase auch dorthin transportiert.

Der Vorgang der gerichteten Erstarrung gemäß vorliegender Erfindung hat aber dennoch mit dem Zonenschmelzen nichts gemein, bei dem bekanntlich eine durch induktive Erwärmung erzeugte zwischen zwei festen Phasen befindliche schmale schmelzflüssige Phase in Richtung der Bootachse bewegt wird.

Nach dem Erkalten des Siliciumbarrens ist es ein leichtes, die freie nahezu plane Oberfläche des erstarrten Siliciumbarrens, in der sich der Großteil der Verunreinigungen befindet, in an sich bekannter Weise abzutragen, vorzugsweise abzuschleifen.

Obwohl jeder erhaltene Siliciumbarren einzeln dem Zonenschmelzen unterworfen werden kann, sieht eine vorteilhafte Weiterbildung der Erfindung vor, zwei gegeneinander gelegte und geeignet halbzylindrische Barren gemeinsam dem Zonenschmelzverfahren zu unterziehen.

Die Vorrichtung zur Durchführung des erfindungsgemäßen Verfahrens besteht im wesentlichen aus einem horizontal angeordneten Graphitboot, bei dem über seine Gesamtlänge hinweg sowohl oberhalb als auch unterhalb des Bootes eine in seiner Intensität getrennt steuerbare Heizvorrichtung angeordnet ist. Die Heizvorrichtung besteht im einfachsten Fall in einer der Bootsform angepaßten, auch direkten Stromdurchgang erhitzten Graphitscheibe. Sollen aber die Bootenden auf höhere Temperatur als im Mittelbereich gebracht werden, ist es besser, als Heizvorrichtung eine der Bootsform angepaßte Keramikscheibe, die mit einzelnen Heizelementen bestückt ist, zu verwenden.

Zweckmäßigerweise besitzt das Boot bei einer Länge von 50 bis 150 cm für die aufzunehmende Schmelze einen nahezu halbkreisförmigen Querschnitt mit einem Durchmesser von 30 bis 100 mm. Zur Vermeidung von Siliciumcarbidbildung ist es sinnvoll, die Bootsinnenseite entweder mit vergütetem Graphit oder mit Quarzsand zu beschichten.

Die Erfindung wird anhand zweier als Ausführungsbeispiele zu wertender Figuren näher erläutert.

Kernstück der Gießanordnung ist das horizontal angeordnete Graphitboot 1, das bei einer Länge von 100 cm einen Innendurchmesser von 75 mm für seinen halbkreisförmigen Querschnitt hat. Unterhalb des Bootes befindet sich die als Keramikscheibe 2 und oberhalb des Bootes die als Keramikscheibe 3 ausgebildeten Heizungen. Beide Scheiben sind mit in der Figur nicht näher dargestellten Heizelementen bestückt. Sie sind unabhängig voneinander steuerbar, daß sie sowohl die Intensität in der Gesamtheit gleichmäßig zu regeln gestatten als auch mehrere unterschiedlich stark beheizte Zonen bilden können, mit denen einzelne Bereiche, z. B. die Bootsenden, eine intensivere Beheizung erfahren können. Außer dieser individuellen Reglung eines jeden Heizkreises 2 bzw. 3 muß der Heizer 2 gegenüber dem Heizer 3 so gesteuert werden, daß die Erstarrungsfront des in das Boot 1 eingefüllten flüssigen Siliciums 4 von unten, dem Gefäßboden, nach oben, der freien Oberfläche, fortschreitet.

Nach dem Erkalten wird der Siliciumbarren dem Boot entnommen und die nahezu ebene Oberfläche abgeschliffen, die Stärke der abzutragenden Schicht wird im allgemeinen 2 mm kaum überschreiten müssen, sie hängt aber von der Reinheit des Ausgangsmaterials ab; auch die gewünschte Reinheit des Endproduktes muß in die Überlegung miteinbezogen werden, wenn der Aufwand beim nachfolgenden Zonenschmelzen nicht zu groß werden darf.

0095707

VPA 82 P 8014 E

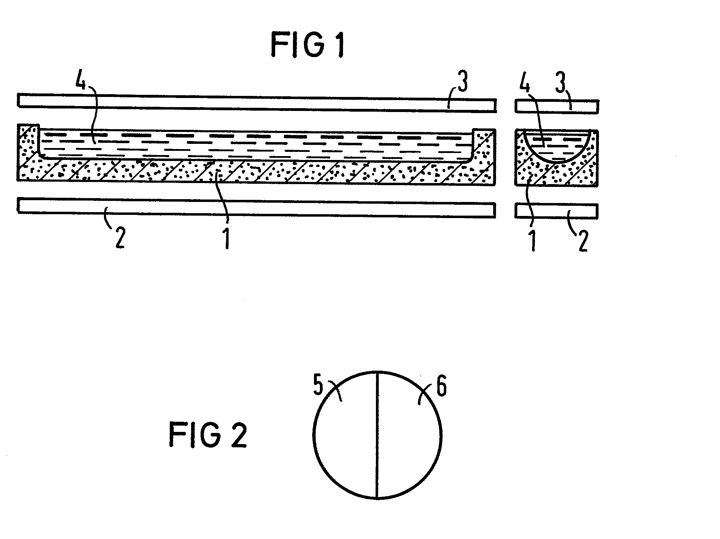

Beim Zonenschmelzen können Kosten noch dadurch gespart werden, wenn, wie in Fig. 2 angedeutet, die beiden halbzylindrischen Barren 5 und 6 mit den abgetragenen ebenen Oberflächen gegeneinander gelegt und geeignet vorgespannt gemeinsam zonengezogen werden, so daß ein einziger reiner und falls gewünscht auch versetzungsfreier einkristalliner Siliciumstab entsteht.

0095707

## Patentansprüche

1. Verfahren zum Herstellen polykristalliner, für nachfolgendes Zonenschmelzen geeigneter Siliciumstäbe durch Gießen flüssigen Siliciums in formgebende Behältnisse mit anschließendem Erstarrenlassen, d a - d u r c h   g e k e n n z e i c h n e t, daß die Siliciumschmelze in ein horizontal angeordnetes Boot gefüllt und danach mittels eines durch hierfür vorgesehene Zusatzheizer erzeugten, über die Bootlänge nahezu konstanten, vom Bootboden zur freien Oberfläche der Schmelze verlaufenden Temperaturgradienten gesteuert zum Erstarren gebracht wird.

2. Verfahren nach Anspruch 1, d a d u r c h   g e - k e n n z e i c h n e t, daß der Temperaturgradient für die programmierte Abkühlung vom Bootboden zur freien Oberfläche hin durch zwei längs des Bootes verlaufende Heizvorrichtungen erzeugt wird.

3. Verfahren nach Anspruch 1 und 2, d a d u r c h   g e k e n n z e i c h n e t, daß die Erstarrungsgeschwindigkeit auf 1 bis 5 mm pro Minute eingestellt wird.

4. Verfahren nach wenigstens einem der Ansprüche 1 bis 3, d a d u r c h   g e k e n n z e i c h n e t, daß ein zusätzlicher in Längsrichtung des Bootes von den Bootenden zur Mitte hin verlaufender Temperaturgradient während des Erstarrens aufrechterhalten wird.

5. Verfahren nach wenigstens einem der Ansprüche 1 bis 4, d a d u r c h   g e k e n n z e i c h n e t, daß der Gießvorgang im Vakuum durchgeführt wird.

0095707

6. Verfahren nach wenigstens einem der Ansprüche 1 bis 4, d a d u r c h   g e k e n n z e i c h n e t, daß der Gießvorgang im Schutzgas, z. B. Argon, bei reduziertem Druck durchgeführt wird.

7. Verfahren nach Anspruch 6, d a d u r c h   g e - k e n n z e i c h n e t, daß der Gießvorgang bei einem Argonpartialdruck von 10 Torr durchgeführt wird.

8. Verfahren nach wenigstens einem der Ansprüche 1 bis 7, d a d u r c h   g e k e n n z e i c h n   e t, daß die freie nahezu plane Oberfläche des gegossenen und erstarrten Siliciumbarrens abgetragen, vorzugsweise abgeschliffen wird.

9. Verfahren nach wenigstens einem der Ansprüche 1 bis 8, d a d u r c h   g e k e n n z e i c h n e t, daß zwei gegeneinander gelegte und geeignet verspannte halbzylindrische Barren gemeinsam dem Zonenschmelzverfahren unterzogen werden.

10. Vorrichtung zur Durchführung des Verfahrens nach Anspruch 1 bis 9, d a d u r c h   g e k e n n - z e i c h n e t, daß ein horizontal angeordnetes aus Graphit bestehendes Boot Verwendung findet, und daß sowohl oberhalb als auch unterhalb des Bootes über seine Gesamtlänge hinweg eine in seiner Intensität getrennt steuerbare Heizvorrichtung angeordnet ist.

11. Vorrichtung nach Anspruch 10, d a d u r c h   g e - k e n n z e i c h n e t, daß als Heizvorrichtung eine der Bootsform angepaßte durch direkten Stromdurchgang erhitzte Graphitscheibe vorgesehen ist.

12. Vorrichtung nach Anspruch 10, d a d u r c h   g e - k e n n z e i c h n e t, daß als Heizvorrichtung

0095707

eine der Bootsform angepaßte mit Heizelementen versehene Keramikscheibe vorgesehen ist.

13. Vorrichtung nach wenigstens einem der Ansprüche 10 bis 12, d a d u r c h   g e k e n n z e i c h n e t , daß die Heizelemente an den Bootsenden auf höhere Temperatur als im Mittelbereich gebracht werden.

14. Vorrichtung nach wenigstens einem der Ansprüche 1 bis 13, d a d u r c h   g e k e n n z e i c h n e t , daß das Boot bei einer Länge von 50 bis 150 cm für die aufzunehmende Schmelze einen nahezu halbkreisförmigen Querschnitt mit einem Durchmesser von 30 bis 100 mm besitzt.

15. Vorrichtung nach wenigstens einem der Ansprüche 1 bis 14, d a d u r c h   g e k e n n z e i c h n e t , daß die Bootsinnenseite mit vergütetem Graphit beschichtet ist.

16. Vorrichtung nach wenigstens einem der Ansprüche 1 bis 14, d a d u r c h   g e k e n n z e i c h n e t , daß die Bootsinnenseite mit Quarzsand beschichtet ist.

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.³) |
|---|---|---|---|
| A | EP-A-0 007 063 (C.G.E.) | | C 30 B 13/00<br>C 01 B 33/02<br>C 30 B 29/06<br>C 30 B 11/00 |
| A | US-A-4 242 175 (A.D. ZUMBRUNNEN) | | |
| A | US-A-3 868 435 (H. DAXER) | | |

| RECHERCHIERTE SACHGEBIETE (Int. Cl.³) |
|---|
| C 30 B 13/00<br>C 30 B 11/00<br>C 01 B 33/02<br>C 30 B 29/06 |

Der vorliegende Recherchenbericht wurde für alle Patentansprüche erstellt.

| Recherchenort | Abschlußdatum der Recherche | Prüfer |
|---|---|---|
| DEN HAAG | 06-09-1983 | BRACKE P.P.J.L. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82